# EUROPEAN PATENT SPECIFICATION

(11) **EP 4 586 640 B1**
(45) Date of publication and mention of the grant of the patent: **11.11.2026**
(21) Application number: 22958200.2
(22) Date of filing: 02.12.2022
(51) Int. Cl.: G10L 21/038, H04R 3/00, H04R 3/04, H03G 3/30, H03G 5/16, H03G 9/02

(54) **AUDIO SIGNAL PROCESSING DEVICE, AUDIO SIGNAL PROCESSING METHOD, AND PROGRAM**
AUDIOSIGNALVERARBEITUNGSVORRICHTUNG, AUDIOSIGNALVERARBEITUNGSVERFAHREN UND PROGRAMM
DISPOSITIF DE TRAITEMENT DE SIGNAL AUDIO, PROCÉDÉ DE TRAITEMENT DE SIGNAL AUDIO ET PROGRAMME

(30) Priority: 05.09.2022 JP 2022141047
(43) Date of publication of application: 16.07.2025
(73) Proprietor: Panasonic Intellectual Property Management Co., Ltd., Kadoma-shi, Osaka 571-0057 (JP)
(72) Inventor: YAMAO, Takashi, Kadoma-shi, Osaka 571-0057 (JP); KAKUHARI, Isao, Kadoma-shi, Osaka 571-0057 (JP); OKUDA, Tadayoshi, Kadoma-shi, Osaka 571-0057 (JP)
(74) Representative: Novagraaf International SA
(86) International application number: PCT/JP2022/044499
(87) International publication number: WO 2024/053122

(56) References cited:
- JP-A- 2003 015 695
- JP-A- 2005 128 387
- JP-A- 2010 081 208
- JP-A- H0 955 634
- JP-B2- H 082 119
- US-A1- 2013 016 856

## Description

### [Technical Field]

The embodiments of the present invention relate to an audio signal processing device, an audio signal processing method, and a program.

### [Background Art]

Patent Literature (PTL) 1 discloses a technique for expanding the high-frequency range of an audio signal.

### [Citation List]

### [Patent Literature]

[PTL 1]
   International Publication No. WO2000/070769
[PTL 2]
   United States Patent Application No. US 2013/016856 A1
[PTL 3]
   Japanese Patent Application No. JP H09 55634 A

### [Summary of Invention]

### [Technical Problem]

The embodiments of the present invention provide an audio signal processing device and the like that can easily expand the high-frequency range of an audio signal that does not have 1/f characteristics, which are characteristics as found in audio signals such as some natural sound, thereby reducing discomfort imparted to a person.

### [Solution to Problem]

In accordance with an aspect of the embodiments of the present invention, there is provided an audio signal processing device, comprising an audio signal processing device as claimed in appended claim 1.

In accordance with another aspect of the embodiments of the present invention, there is provided an audio signal processing method, comprising an audio signal processing method as claimed in appended claim 13. In accordance with yet another aspect of the embodiments of the present invention, there is provided a program, comprising a program as claimed in appended claim 14.

General or specific aspects of the embodiments of the present invention may be implemented to a device, an integrated circuit, a computer program, a non-transitory computer-readable recording medium such as a Compact Disc-Read Only Memory (CD-ROM), or any given combination thereof.

### [Advantageous Effect of Invention]

An audio signal processing device and the like of the embodiments of the present invention can easily expand the high-frequency range of an audio signal that does not have 1/f characteristics, which are characteristics as found in audio signals such as some natural sound, thereby reducing discomfort imparted to a person.

### [Brief Description of Drawings]

[FIG. 1]

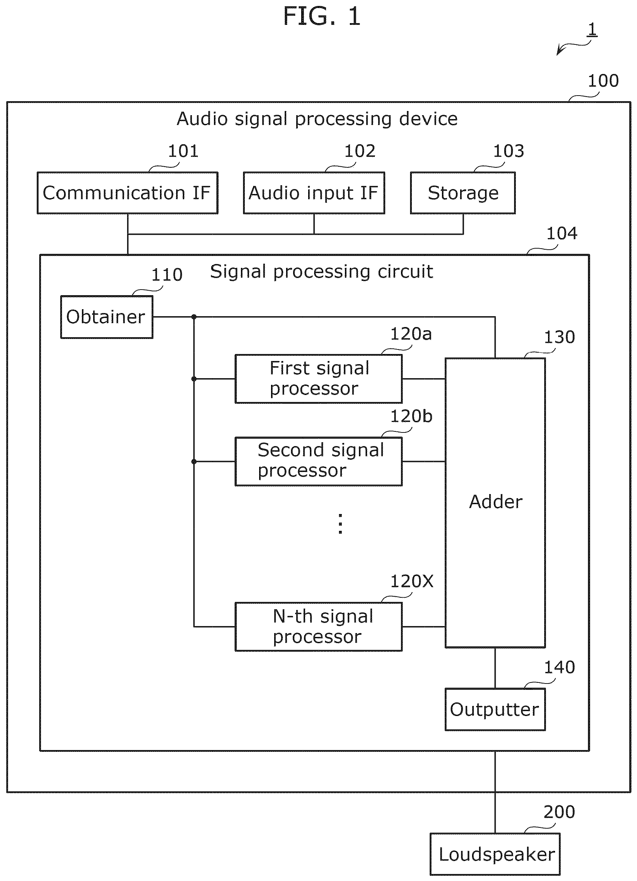

   FIG. 1 is a block diagram illustrating an example of the configuration of an audio signal processing system according to an embodiment.
[FIG. 2]

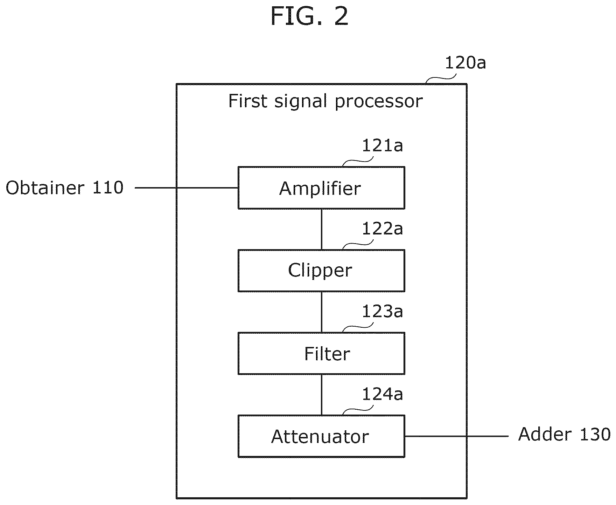

   FIG. 2 is a diagram illustrating an example of the configuration of a first signal processor according to the embodiment.
[FIG. 3]

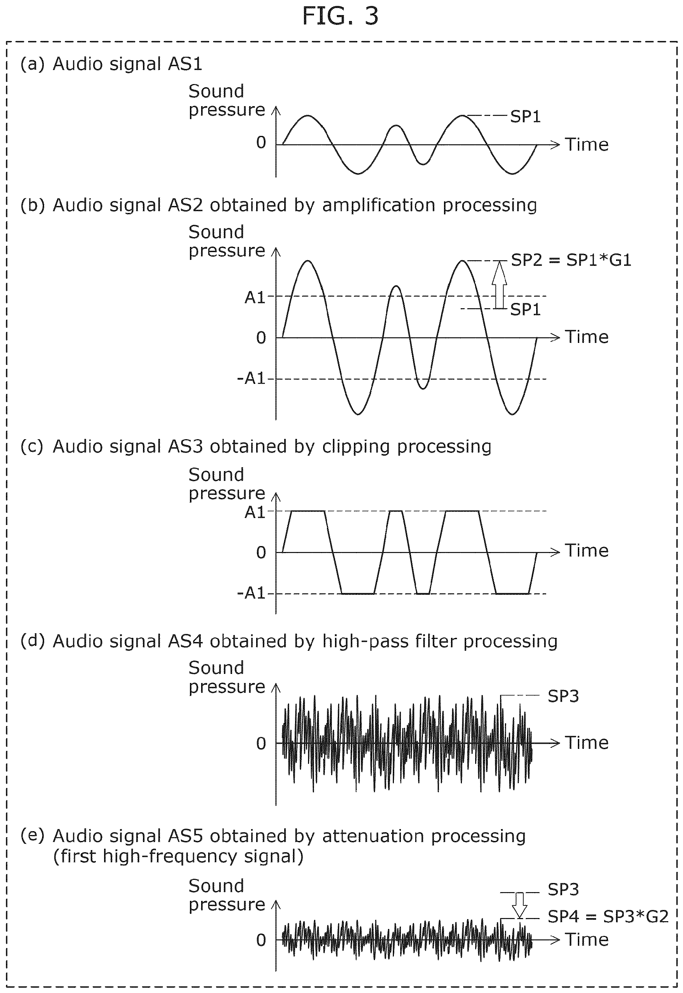

   FIG. 3 is a diagram illustrating an example of waveforms of audio signals before and after respective processing operations for describing each processing performed by the first signal processor according to the embodiment.
[FIG. 4]

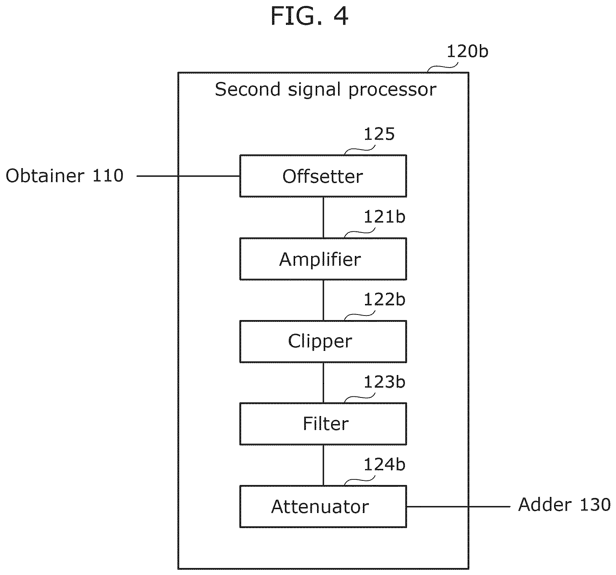

   FIG. 4 is a diagram illustrating an example of the configuration of a second signal processor according to the embodiment.
[FIG. 5]

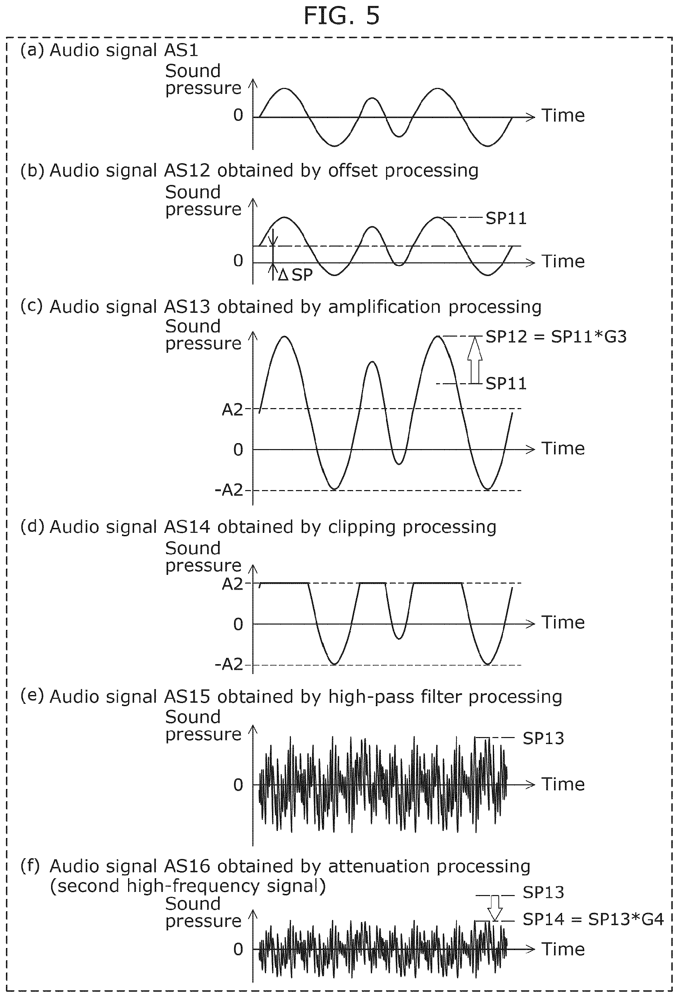

   FIG. 5 is a diagram illustrating an example of waveforms of audio signals before and after respective processing operations for describing each processing performed by the second signal processor according to the embodiment.
[FIG. 6]

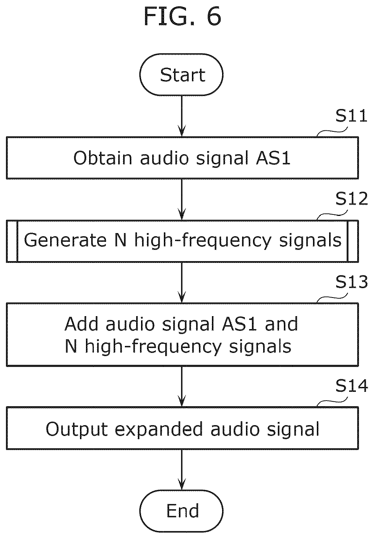

   FIG. 6 is a flowchart illustrating an example of audio signal processing of the audio signal processing device according to the embodiment.
[FIG. 7]

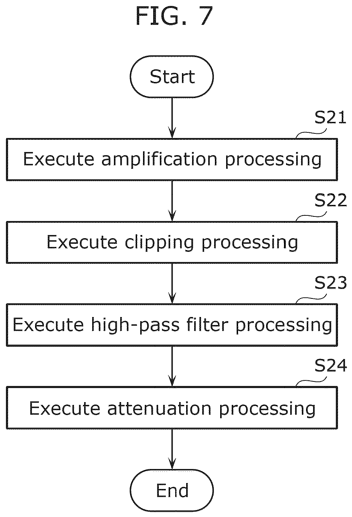

   FIG. 7 is a flowchart illustrating an example of processing that generates a first high-frequency signal among N high-frequency signals according to the embodiment.
[FIG. 8]

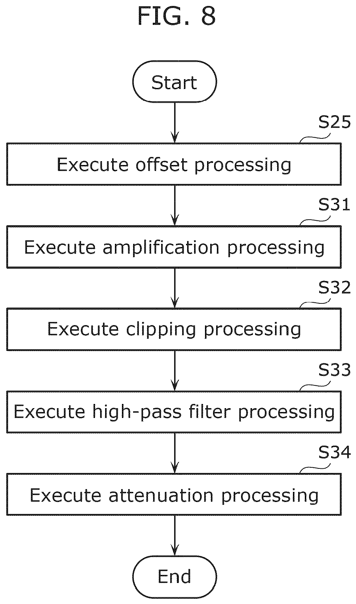

   FIG. 8 is a flowchart illustrating an example of operation that generates a second high-frequency signal among N high-frequency signals according to the embodiment.

### [Description of Embodiments]

### (Underlying Knowledge Forming Basis of the Present Disclosure)

The technique described in PTL 1 is based on the premise of performing filter processing by using a 1/f characteristic filter, and therefore consideration is not given to expanding the high-frequency range of an audio signal that does not have 1/f characteristics which are found in some natural sound or the like. In other words, in the conventional technique, there is a problem that it is difficult to expand the high-frequency range of such an audio signal in order to reduce discomfort imparted to a person.

As a result of diligent studies, the inventors of the present invention have developed an audio signal processing device, an audio signal processing method, and a program, which are described hereunder, in order to expand the high-frequency range of an audio signal that does not have 1/f characteristics, which are characteristics as found in audio signals such as some natural sound, thereby reducing discomfort imparted to a person.

An audio signal processing device according to a first aspect of the present disclosure includes: an obtainer that obtains an audio signal; a first signal processor that generates, based on the audio signal, a first high-frequency signal including a high-frequency component in a frequency band higher than a first frequency higher than a human hearing range; and an adder that adds the first high-frequency signal to the audio signal to generate an expanded audio signal having an expanded high-frequency range, wherein the first signal processor generates the first high-frequency signal by performing: (i) first signal processing including first clipping processing of clipping the audio signal at a first amplitude; and (ii) first high-pass filter processing of passing an audio signal obtained by the first clipping processing through the frequency band higher than the first frequency.

According to this, by performing first clipping processing of clipping, at a first amplitude, an audio signal obtained by the first amplification processing, an audio signal that includes more high-frequency components (harmonic components) which are based on the original audio signal can be generated. Further, since first high-pass filter processing is performed on the audio signal obtained by the first clipping processing, a first high-frequency signal that has a high sound pressure mainly in the high-frequency range can be generated, and by adding the first high-frequency signal to the original audio signal, an expanded audio signal in which the high-frequency range of the original audio signal has been expanded can be generated. Thus, it is possible to easily expand the high-frequency range of an audio signal that does not have 1/f characteristics, which are characteristics as found in audio signals such as some natural sound, thereby reducing discomfort imparted to a person.

The audio signal processing device according to a second aspect of the present disclosure is the audio signal processing device according to the first aspect wherein the first signal processing includes: first amplification processing of amplifying the audio signal by a first gain, and in the first clipping processing, an audio signal obtained by the first amplification processing is clipped as the audio signal.

According to this, since a slope of a waveform of the original audio signal in a sound pressure range that is based on the first amplitude can be made steeper by the amplification processing as compared to before the amplification processing, the angle of a bent shape of the waveform of the audio signal obtained by the clipping processing can be made close to 90 degrees. Hence, an audio signal that includes more high-frequency components (for example, high-frequency components that are higher than the frequency band of the original audio signal and that fall within the inaudible range of human hearing) can be generated.

The audio signal processing device according to a third aspect of the present disclosure is the audio signal processing device according to the first or second aspect, wherein the first signal processor further performs first attenuation processing of attenuating, by a second gain, the audio signal obtained by the first clipping processing, and the first high-frequency signal is an audio signal obtained by the first attenuation processing.

Therefore, adjustment of the amplitude of the audio signal obtained by the first clipping processing that includes more high-frequency components which are based on the original audio signal can be performed. Thus, a first high-frequency signal whose amplitude has been appropriately adjusted can be generated, and the high-frequency range of the original audio signal can be appropriately expanded.

The audio signal processing device according to a fourth aspect of the present disclosure is the audio signal processing device according to the first or second aspect, wherein the first signal processor further performs first equalizing processing of amplifying or attenuating a certain frequency band of an audio signal obtained by the first high-pass filter processing, and the first high-frequency signal is an audio signal obtained by the first equalizing processing.

Therefore, adjustment of the frequency characteristics of an audio signal obtained by the first high-pass filter processing can be performed. Thus, a first high-frequency signal whose amplitude has been appropriately adjusted can be generated, and the high-frequency range of the original audio signal can be appropriately expanded.

The audio signal processing device according to a fifth aspect of the present disclosure is the audio signal processing device according to the first or second aspect, wherein the first signal processor further performs: first attenuation processing of attenuating, by a second gain, the audio signal obtained by the first clipping processing; and first equalizing processing of amplifying or attenuating a certain frequency band of an audio signal obtained by the first attenuation processing, and the first high-frequency signal is an audio signal obtained by the first equalizing processing.

Therefore, adjustment of the amplitude and frequency characteristics of an audio signal obtained by the first high-pass filter processing can be performed. Thus, a first high-frequency signal whose amplitude has been appropriately adjusted can be generated, and the high-frequency range of the original audio signal can be appropriately expanded.

The audio signal processing device according to a sixth aspect of the present disclosure is the audio signal processing device according to any one of the first to fifth aspects which further includes: a second signal processor that generates, based on the audio signal, a second high-frequency signal different from the first high-frequency signal, wherein the second signal processor generates the second high-frequency signal by performing: (i) second signal processing including offset processing of offsetting the audio signal by a predetermined sound pressure; (ii) second clipping processing of clipping, at a second amplitude, an audio signal obtained by the second signal processing; and (iii) second high-pass filter processing of passing an audio signal obtained by the second clipping processing through a frequency band higher than a second frequency higher than the human hearing range, and the adder generates the expanded audio signal by adding the first high-frequency signal and the second high-frequency signal to the audio signal.

According to this, by performing second clipping processing of clipping, at a second amplitude, an audio signal obtained by the offset processing and the second amplification processing, an audio signal that includes more high-frequency components which are based on the original audio signal can be generated. In a case where an audio signal obtained by the first clipping processing is subjected to clipping processing without being subjected to offset processing, the audio signal includes many odd order frequency components, and because an audio signal obtained by the second clipping processing is subjected to the clipping processing after being subjected to offset processing, the audio signal obtained by the second clipping processing includes many even order frequency components. Therefore, in this case the frequency characteristics of a first high-frequency signal and a second high-frequency signal can be made to differ from each other, and the high-frequency range of the original audio signal can be expanded more effectively.

The audio signal processing device according to a seventh aspect of the present disclosure is the audio signal processing device according to the sixth aspect, wherein the second signal processing includes: the offset processing; and second amplification processing of amplifying, by a third gain, an audio signal obtained by the offset processing.

According to this, since a slope of a waveform of the audio signal obtained by the offset processing in a sound pressure range that is based on the second amplitude can be made steeper by the amplification processing as compared to before the amplification processing, the angle of a bent shape of the waveform of the audio signal obtained by the clipping processing can be made close to 90 degrees. Hence, an audio signal that includes more high-frequency components (for example, high-frequency components that are higher than the frequency band of the original audio signal and that fall within the inaudible range of human hearing) can be generated.

The audio signal processing device according to an eighth aspect of the present disclosure is the audio signal processing device according to the sixth or seventh aspect, wherein the second signal processor further performs second attenuation processing of attenuating, by a fourth gain, the audio signal obtained by the second clipping processing, and the second high-frequency signal is an audio signal obtained by the second attenuation processing.

Therefore, adjustment of the amplitude of the audio signal obtained by the second clipping processing that includes more high-frequency components which are based on the original audio signal can be performed. Thus, a second high-frequency signal whose amplitude has been appropriately adjusted can be generated, and the high-frequency range of the original audio signal can be more appropriately expanded.

The audio signal processing device according to a ninth aspect of the present disclosure is the audio signal processing device according to the sixth or seventh aspect, wherein the second signal processor further performs second equalizing processing of amplifying or attenuating a certain frequency range of an audio signal obtained by the second high-pass filter processing, and the second high-frequency signal is an audio signal obtained by the second equalizing processing.

Therefore, adjustment of the frequency characteristics of an audio signal obtained by the second high-pass filter processing can be performed. Thus, a second high-frequency signal whose amplitude has been appropriately adjusted can be generated, and the high-frequency range of the original audio signal can be more appropriately expanded.

The audio signal processing device according to a tenth aspect of the present disclosure is the audio signal processing device according to the sixth or seventh aspect, wherein the second signal processor further performs: second attenuation processing of attenuating, by a fourth gain, the audio signal obtained by the second clipping processing; and second equalizing processing of amplifying or attenuating a certain frequency range of an audio signal obtained by the second attenuation processing, and the second high-frequency signal is an audio signal obtained by the second equalizing processing.

Therefore, adjustment of the amplitude and the frequency characteristics of an audio signal obtained by the second high-pass filter processing can be performed. Thus, a second high-frequency signal whose amplitude has been appropriately adjusted can be generated, and the high-frequency range of the original audio signal can be more appropriately expanded.

The audio signal processing device according to an eleventh aspect of the present disclosure is the audio signal processing device according to any one of the first to fifth aspects which further includes: a third signal processor that generates, based on the audio signal, a third high-frequency signal different from the first high-frequency signal, wherein the third signal processor generates the third high-frequency signal by performing: (i) third amplification processing of amplifying the audio signal by a fifth gain; (ii) third clipping processing of clipping, at a third amplitude, an audio signal obtained by the third amplification processing; and (iii) third high-pass filter processing of passing an audio signal obtained by the third clipping processing through a frequency band higher than a third frequency higher than the human hearing range, and the adder generates the expanded audio signal by adding the first high-frequency signal and the third high-frequency signal to the audio signal.

According to this, by performing third clipping processing of clipping, at a third amplitude, an audio signal obtained by the third amplification processing, an audio signal that includes more high-frequency components which are based on the original audio signal can be generated. Further, since third high-pass filter processing is performed on the audio signal obtained by the third clipping processing, a third high-frequency signal that has a high sound pressure mainly in the high-frequency range can be generated. Thus, by adding the first high-frequency signal and the third high-frequency signal to the original audio signal, an expanded audio signal in which the high-frequency range of the original audio signal has been expanded more effectively can be generated.

The audio signal processing device according to a twelfth aspect of the present disclosure is the audio signal processing device according to the eleventh aspect, wherein values are different from each other in at least one set among (i) a set of a value of the first gain and a value of the fifth gain, (ii) a set of a value of the first amplitude and a value of the third amplitude, and (iii) a set of a value of the first frequency and a value of the third frequency.

According to this, since values are different from each other in at least one set among a set of a value of the first gain and a value of the fifth gain, a set of a value of the first amplitude and a value of the third amplitude, and a set of a value of the first frequency and a value of the third frequency, the third high-frequency signal can be generated by processing that is different from the processing that generates the first high-frequency signal. Therefore, the frequency characteristics of the first high-frequency signal and the third high-frequency signal can be made to differ from each other. Thus, by adding the first high-frequency signal and the third high-frequency signal to the original audio signal, an expanded audio signal in which the high-frequency range of the original audio signal has been expanded more effectively can be generated.

An audio signal processing method according to a thirteenth aspect of the present disclosure includes: obtaining an audio signal; generating, based on the audio signal, a first high-frequency signal including a high-frequency component in a frequency band higher than a first frequency higher than a human hearing range; and adding the first high-frequency signal to the audio signal to generate an expanded audio signal having an expanded high-frequency range, wherein the generating of the first high-frequency signal includes: (i) first signal processing including first clipping processing of clipping the audio signal at a first amplitude; and (ii) first high-pass filter processing of passing an audio signal obtained by the first clipping processing through the frequency band higher than the first frequency.

According to this, by performing first clipping processing of clipping, at a first amplitude, an audio signal obtained by the first amplification processing, an audio signal that includes more high-frequency components which are based on the original audio signal can be generated. Further, since first high-pass filter processing is performed on the audio signal obtained by the first clipping processing, a first high-frequency signal that has a high sound pressure mainly in the high-frequency range can be generated, and by adding the first high-frequency signal to the original audio signal, an expanded audio signal in which the high-frequency range of the original audio signal has been expanded can be generated. Thus, it is possible to easily expand the high-frequency range of an audio signal that does not have 1/f characteristics, which are characteristics as found in audio signals such as some natural sound, thereby reducing discomfort imparted to a person.

A program according to a fourteenth aspect of the present disclosure is a program for causing a computer to execute the audio signal processing method according to the thirteenth aspect.

General or specific aspects of the present disclosure may be implemented to a device, an integrated circuit, a computer program, a non-transitory computer-readable recording medium such as a Compact Disc-Read Only Memory (CD-ROM), or any given combination thereof.

Hereinafter, certain exemplary embodiments will be described in detail with reference to the accompanying Drawings. Hereinafter, certain exemplary embodiments will be described in detail with reference to the accompanying Drawings. However, unnecessarily detailed description may be omitted. For example, detailed explanation of a well-known matter and repeated description of substantially identical structures may be omitted. Such omission makes the following description exclude unnecessary redundancy and be easily understood by those skilled in the art.

It should be noted that the accompanying drawings and subsequent description are provided by the inventors of the present invention to facilitate sufficient understanding of the present disclosure by those skilled in the art, and are thus not intended to limit the scope of the subject matter recited in the claims.

### (Embodiment)

### [1. Configuration]

FIG. 1 is a block diagram illustrating an example of the configuration of audio signal processing system 1 according to an embodiment.

Audio signal processing system 1 is a system that generates and outputs audio in which the high-frequency range of audio signal AS1 (original audio signal) that is a sound source has been expanded. Audio signal processing system 1 includes audio signal processing device 100 and loudspeaker 200 as illustrated in FIG. 1.

Audio signal processing device 100 is a device that performs signal processing on audio signal AS1 that is the sound source to expand the high-frequency range of audio signal AS1. Audio signal processing device 100 outputs an expanded audio signal in which the high-frequency range of audio signal AS1 has been expanded. Audio signal processing device 100 may be realized by, for example, an AV (audio-visual) device such as an amplifier device (a preamplifier, integrated amplifier, or the like), a TV, a recording/playback device, or an STB (set-top box), or may be realized by an information processing terminal such as a PC (personal computer), a smartphone, or a tablet terminal.

Loudspeaker 200 outputs output audio generated based on an expanded audio signal that is output from audio signal processing device 100. Loudspeaker 200 may be a passive loudspeaker connected to an amplifier device, or may be an active loudspeaker with a built-in amplifier. Further, loudspeaker 200 may be a loudspeaker included in a TV, a smartphone, or a tablet terminal. In such a case, audio signal processing system 1 may be realized by a single device such as a TV, a smartphone, or a tablet terminal.

### <Configuration of audio signal processing device>

Audio signal processing device 100 includes communication IF (interface) 101, audio input IF (interface) 102, storage 103, and signal processing circuit 104.

Communication IF 101 is an interface for performing communication with an external device. For example, communication IF 101 may obtain audio signal AS1 as a sound source from an external device by performing communication with the external device. Communication IF 101 may perform communication with an external device via a network, or may perform communication directly with an external device. The external device that performs communication may be a server, or may be a mobile terminal such as a smartphone or a tablet terminal. Communication IF 101 may be a wireless communication interface, or may be a wired communication interface. Examples of the wireless communication interface include a wireless LAN and Bluetooth (registered trademark). Examples of the wired communication interface include a wired LAN. The wired communication interface may include a USB.

Audio input IF 102 is an interface that accepts audio signal AS1 as a sound source from an external device. Audio input IF 102 includes, for example, an input terminal that accepts input of an analog audio signal such as an RCA terminal or a phone terminal, or an input terminal that accepts input of a digital audio signal such as an optical digital terminal or a coaxial digital terminal. Note that, audio input IF 102 is not limited to an input terminal that accepts input of only an audio signal, and may be an input terminal such as an HDMI (registered trademark) terminal that accepts input of an audio signal together with input of a video signal.

Storage 103 stores audio signal AS1 as a sound source. Storage 103 is, for example, a nonvolatile storage device such as an HDD (hard disk drive), an SSD (solid state drive), or a memory card.

Note that, audio signal processing device 100 need not include each of communication IF 101, audio input IF 102, and storage 103, and it suffices for audio signal processing device 100 to include at least one of communication IF 101, audio input IF 102, and storage 103.

Audio signal AS1 as a sound source is, for example, an audio signal of natural sound (environmental sound) that was captured beforehand in nature, such as the sound of a flowing river or waterfall in a valley, or the sound of insects or birds singing. Note that, audio signal AS1 as a sound source is not limited to such natural sound, and may be an audio signal of music.

Signal processing circuit 104 obtains audio signal AS1 as a sound source, and executes audio signal processing for expanding the high-frequency range on audio signal AS1 to thereby generate an expanded audio signal in which the high-frequency range has been expanded. Signal processing circuit 104 is, for example, a DSP (digital signal processor). Signal processing circuit 104 includes obtainer 110, first to N-th signal processors 120a to 120X, adder 130, and outputter 140. A part or all of the respective functional blocks included in signal processing circuit 104 is realized by a DSP.

Note that, signal processing circuit 104 may include a CPU (central processing unit), and may be constituted by only a CPU. A part or all of the respective functional blocks included in signal processing circuit 104 may be realized by a CPU executing a program stored in the storage or the like.

Obtainer 110 obtains audio signal AS1. Specifically, obtainer 110 obtains audio signal AS1 from at least one of communication IF 101, audio input IF 102, and storage 103.

First to N-th signal processors 120a to 120X are N (N is an integer of 3 or more) signal processors. Each of first to N-th signal processors 120a to 120X generates a high-frequency signal including a component in a frequency band higher than the frequency band of audio signal AS1, based on audio signal AS1. That is, the high-frequency signal is a signal including a component in a high frequency band that is not included in audio signal AS1. Since first to N-th signal processors 120a to 120X execute mutually-different processing, they generate high-frequency signals that are different from each other. That is, first to N-th signal processors 120a to 120X generate N high-frequency signals, and the generated N high-frequency signals are different signals from each other. The specific processing of first to N-th signal processors 120a to 120X is described later.

Adder 130 adds the N high-frequency signals generated by N first to N-th signal processors 120a to 120X to audio signal AS1 obtained by obtainer 110 to generate an expanded audio signal that has an expanded high-frequency range.

Outputter 140 outputs the expanded audio signal generated by adder 130. Specifically, outputter 140 outputs the expanded audio signal to loudspeaker 200. Note that, outputter 140 may output the expanded audio signal to storage 103 to cause storage 103 to store the expanded audio signal. Further, outputter 140 may output the expanded audio signal to an external device via communication IF 101.

### <Configuration of first to N-th signal processors>

FIG. 2 is a diagram illustrating an example of the configuration of first signal processor 120a according to the embodiment. FIG. 3 is a diagram illustrating an example of waveforms of audio signals before and after respective processing operations for describing each processing performed by first signal processor 120a according to the embodiment. For the waveforms of the audio signals illustrated in FIG. 3, the ordinate axis represents sound pressure, and the abscissa axis represents time.

First signal processor 120a includes amplifier 121a, clipper 122a, filter 123a, and attenuator 124a.

Amplifier 121a performs amplification processing of amplifying, by gain G1, audio signal AS1 obtained by obtainer 110. By amplifying the sound pressure of audio signal AS1 illustrated in (a) in FIG. 3 by gain G1 that is larger than 1, amplifier 121a generates audio signal AS2 that is obtained by the amplification processing, that is illustrated in (b) in FIG. 3. By this means, sound pressure SP1 of audio signal AS1 is amplified to sound pressure SP2 (= SP1*G1). The amplification processing by amplifier 121a is an example of first amplification processing. Gain G1 is an example of a first gain.

Clipper 122a performs clipping processing of clipping, at amplitude A1, audio signal AS2 obtained by the amplification processing by amplifier 121. That is, for example, as illustrated in (b) and (c) in FIG. 3, clipper 122a clips audio signal AS2 so that a sound pressure range from -A1 or more to A1 or less remains. As a result, audio signal AS3 having a waveform that includes a shape in which the sound pressure does not change linearly when the sound pressure is A1 and when the sound pressure is -A1 is generated. As illustrated in (c) in FIG. 3, since the waveform of audio signal AS3 has a bent shape at portions including a starting point or an ending point of a linear shape where the sound pressure does not change, audio signal AS3 includes more high-frequency components. In particular, with respect to audio signal AS2, a slope in a sound pressure range from -A1 or more to A1 or less of the waveform of audio signal AS2 can be made steeper by the amplification processing as compared to before the amplification processing. Therefore, an angle of the bent shape of the waveform of audio signal AS3 obtained by the clipping processing can be made an angle that is closer to 90 degrees than an angle of a bent shape produced by clipping the waveform of an audio signal in a case where clipping processing is performed without amplifying audio signal AS1. Note that, making the slope of the waveform steeper means, specifically, increasing the absolute value of the slope of a tangent to the waveform. Hence, audio signal AS3 that includes more high-frequency components (for example, high-frequency components that are higher than the frequency band of original audio signal AS1 and that fall within the inaudible range of human hearing) can be generated. The clipping processing by clipper 122a is an example of first clipping processing. Amplitude A1 is an example of a first amplitude.

Filter 123a performs high-pass filter processing of passing audio signal AS3 obtained by the clipping processing performed by clipper 122a through a frequency band (high-frequency range) higher than frequency f1 that is higher than the human hearing range. Frequency f1 is included in the inaudible range of human hearing. The high-pass filter processing is, in other words, processing performed on audio signal AS3 that cuts off a frequency band (low-frequency range) equal to or lower than frequency f1. By this means, as illustrated in (d) in FIG. 3, filter 123a generates audio signal AS4 in which the sound pressure in the high-frequency range is higher than the sound pressure in the low-frequency range. The high-pass filter processing by filter 123a is an example of first high-pass filter processing. Frequency f1 is an example of a first frequency.

Attenuator 124a performs attenuation processing of attenuating, by gain G2, audio signal AS4 obtained by the high-pass filter processing performed by filter 123a. Attenuator 124a, for example, attenuates the sound pressure of audio signal AS4 illustrated in (d) in FIG. 3 by gain G2 that is less than 1 to thereby generate audio signal AS5 obtained by the attenuation processing that is illustrated in (e) in FIG. 3. As a result, sound pressure SP3 of audio signal AS4 is attenuated to sound pressure SP4 (= SP3*G2). Audio signal AS5 is a first high-frequency signal. The attenuation processing by attenuator 124a is an example of first attenuation processing. Gain G2 is an example of a second gain. Note that, gain G2 may be the reciprocal of gain G1, or may be a value that is different from the reciprocal of gain G1.

Here, although the attenuation processing by attenuator 124a is performed next following the high-pass filter processing by filter 123a, the embodiment is not limited thereto, and the attenuation processing by attenuator 124a may be performed next following the clipping processing by clipper 122a. In such a case, the high-pass filter processing is performed next following the attenuation processing. That is, as long as the attenuation processing is performed after the clipping processing by clipper 122a, the attenuation processing may be performed before or after the high-pass filter processing.

FIG. 4 is a diagram illustrating an example of the configuration of second signal processor 120b according to the embodiment. FIG. 5 is a diagram illustrating an example of waveforms of audio signals before and after respective processing operations for describing each processing performed by second signal processor 120b according to the embodiment. For the waveforms of the audio signals in FIG. 5, the ordinate axis represents sound pressure, and the abscissa axis represents time.

Second signal processor 120b includes offsetter 125, amplifier 121b, clipper 122b, filter 123b, and attenuator 124b.

Offsetter 125 performs offset processing of offsetting audio signal AS1 obtained by obtainer 110 by a predetermined sound pressure. For example, by adding predetermined sound pressure ΔSP to the sound pressure of audio signal AS1 illustrated in (a) in FIG. 5, offsetter 125 generates audio signal AS12 obtained by the offset processing, that is illustrated in (b) in FIG. 5. Note that, offsetter 125 may perform offset processing that subtracts a predetermined sound pressure from the sound pressure of audio signal AS1.

Amplifier 121b performs amplification processing of amplifying, by gain G3, audio signal AS12 obtained by the offset processing by offsetter 125. For example, by amplifying the sound pressure of audio signal AS12 illustrated in (b) in FIG. 5 by gain G3 that is larger than 1, amplifier 121b generates audio signal AS13 that is obtained by the amplification processing, that is illustrated in (c) in FIG. 5. By this means, sound pressure SP11 of audio signal AS12 is amplified to sound pressure SP12 (= SP11*G3). The amplification processing by amplifier 121b is an example of second amplification processing. Gain G3 is an example of a third gain.

Here, although the offset processing by offsetter 125 is performed before the amplification processing by amplifier 121b, the embodiment is not limited thereto, and the offset processing by offsetter 125 may be performed next following the amplification processing by amplifier 121b. As long as the offset processing is performed before clipping processing by clipper 122b, the offset processing may be performed before or after the amplification processing by amplifier 121b.

Clipper 122b performs clipping processing of clipping, at amplitude A2, audio signal AS13 obtained by the amplification processing by amplifier 121b. That is, for example, as illustrated in (c) and (d) in FIG. 5, clipper 122b clips audio signal AS13 so that a sound pressure range from -A2 or more to A2 or less remains. As a result, audio signal AS14 having a waveform that includes a shape in which the sound pressure does not change linearly when the sound pressure is A2 and when the sound pressure is -A2 is generated. As illustrated in (d) in FIG. 5, since the waveform of audio signal AS14 has a bent shape at portions including a starting point or an ending point of a linear shape where the sound pressure does not change, audio signal AS14 includes more high-frequency components. In particular, with respect to audio signal AS13, since a slope in a sound pressure range from -A2 or more to A2 or less of the waveform of audio signal AS13 can be made steeper by the amplification processing as compared to before the amplification processing, an angle of the bent shape of the waveform of audio signal AS14 obtained by the clipping processing can be made an angle that is close to 90 degrees. Hence, audio signal AS14 that includes more high-frequency components can be generated. The clipping processing by clipper 122b is an example of second clipping processing. Amplitude A2 is an example of a second amplitude.

Note that, predetermined sound pressure ΔSP of the offset amount by which offset processing is performed by offsetter 125 may be higher than, lower than, or the same as amplitude A2 at which audio signal AS13 is clipped by clipper 122b.

Filter 123b performs high-pass filter processing of passing audio signal AS14 obtained by the second clipping processing through a frequency band (high-frequency range) higher than frequency f2 that is higher than the human hearing range. Frequency f2 is included in the inaudible range of human hearing. The high-pass filter processing is, in other words, processing performed on audio signal AS14 that cuts off a frequency band (low-frequency range) equal to or lower than frequency f2. By this means, as illustrated in (e) in FIG. 5, filter 123b generates audio signal AS15 in which the sound pressure in the high-frequency range is higher than the sound pressure in the low-frequency range. The high-pass filter processing by filter 123b is an example of second high-pass filter processing. Frequency f2 is an example of a second frequency.

Attenuator 124b performs attenuation processing of attenuating, by gain G4, audio signal AS15 obtained by the high-pass filter processing performed by filter 123b. Attenuator 124b, for example, attenuates the sound pressure of audio signal AS15 illustrated in (e) in FIG. 5 by gain G4 that is less than 1 to thereby generate audio signal AS16 obtained by the attenuation processing that is illustrated in (f) in FIG. 5. As a result, sound pressure SP13 of audio signal AS15 is attenuated to sound pressure SP14 (= SP13*G4). Audio signal AS16 is a second high-frequency signal. The attenuation processing by attenuator 124b is an example of second attenuation processing. Gain G4 is an example of a fourth gain. Note that, gain G4 may be the reciprocal of gain G3, or may be a value that is different from the reciprocal of gain G3.

Here, although the attenuation processing by attenuator 124b is performed next following the high-pass filter processing by filter 123b, the embodiment is not limited thereto, and the attenuation processing by attenuator 124b may be performed next following the clipping processing by clipper 122b. In such a case, the high-pass filter processing is performed next following the attenuation processing. That is, as long as the attenuation processing is performed after the clipping processing by clipper 122b, the attenuation processing may be performed before or after the high-pass filter processing.

Note that, parameters used in each processing operation performed in first signal processor 120a and second signal processor 120b may be the same as each other or may be different from each other. Specifically, gain G1 that is a parameter used in the amplification processing by amplifier 121a and gain G3 that is a parameter used in the amplification processing by amplifier 121b may be the same or different. Further, amplitude A1 that is a parameter used in the clipping processing by clipper 122a and amplitude A2 that is a parameter used in the clipping processing by clipper 122b may be the same or different. Further, frequency f1 that is a parameter used in the high-pass filter processing by filter 123a and frequency f2 that is a parameter used in the high-pass filter processing by filter 123b may be the same or different. Further, gain G2 that is a parameter used in the attenuation processing by attenuator 124a and gain G4 that is a parameter used in the attenuation processing by attenuator 124b may be the same or different.

Further, among N first to N-th signal processors 120a to 120X, another signal processor apart from first signal processor 120a and second signal processor 120b may have any kind of configuration as long as the other signal processor can generate a high-frequency signal by processing that is different from the processing of first signal processor 120a and the processing of second signal processor 120b.

The other signal processor, for example, may have the same processing units as first signal processor 120a, and any parameter used in the processing of the respective processing units may be different from a parameter used in the processing of first signal processor 120a. Specifically, the other signal processor may have: an amplifier that performs amplification processing (third amplification processing) of amplifying audio signal AS1 by gain G5; a clipper that performs clipping processing (third clipping processing) of clipping, at amplitude A3, an audio signal obtained by the amplification processing (third amplification processing); a filter that performs high-pass filter processing (third high-pass filter processing) of passing an audio signal obtained by the clipping processing (third clipping processing) through a frequency band higher than frequency f3 that is higher than the human hearing range; and an attenuator that performs attenuation processing of attenuating, by gain G6, an audio signal obtained by the high-pass filter processing (third high-pass filter processing). Further, it suffices that any parameter used in the respective processing operations is different from a parameter used in the respective processing operations of first signal processor 120a. That is, it suffices that values are different from each other in at least one set among a set of a value of gain G1 and a value of gain G5, a set of a value of amplitude A1 and a value of amplitude A3, a set of a value of frequency f1 and a value of frequency f3, and a set of a value of gain G2 and a value of gain G6. The other signal processor in this case is an example of a third signal processor.

Further, for example, similarly to the configuration described above, the other signal processor may have the same processing units as second signal processor 120b, and any parameter used in the processing of the respective processing units may be different from a parameter used in the processing of second signal processor 120b. That is, a parameter used in the processing of at least one processing unit among the plurality of processing units (offsetter, amplifier, clipper, filter, and attenuator) of the other signal processor may be different from a parameter used in the processing of at least one processing unit corresponding to the aforementioned at least one processing unit, among the plurality of processing units (offsetter 125, amplifier 121b, clipper 122b, filter 123b, and attenuator 124b) of second signal processor 120b.

The other signal processor may also have an equalizer. The equalizer performs equalizing processing for amplifying or attenuating a certain frequency band of an audio signal obtained by high-pass filter processing. The equalizing processing is processing that, with respect to the frequency of the audio signal to be processed, makes different gain adjustments for a first band, and a second band that is different from the first band. The different gain adjustments may be amplification processing and attenuation processing, or may be processing with different gains in amplification processing, or may be processing with different gains in attenuation processing. Therefore, adjustment of the frequency characteristics of an audio signal obtained by high-pass filter processing can be performed. By this means, a high-frequency signal whose amplitude has been appropriately adjusted can be generated, and the high-frequency range of the audio signal can be appropriately expanded.

The equalizing processing may include attenuation processing in an attenuator. That is, the equalizing processing may include processing that attenuates the entire frequency band. In this case, the other signal processor need not have an attenuator.

Further, among an amplifier, a clipper, a filter, an attenuator, an equalizer, and an offsetter, it suffices that the other signal processor has at least a clipper and a filter.

Furthermore, in a case where the configuration of processing units (combination of processing units) that the other signal processor has is the same, it suffices that at least one parameter among the parameters used in the respective processing operations is different from a parameter which is among parameters used in respective processing operations of the signal processor that has the same combination of processing units and which is a parameter used in processing corresponding to the aforementioned at least one parameter.

Therefore, with respect to N first to N-th signal processors 120a to 120X, because either the combinations of processing units are different from each other or, even when the combinations of processing units are the same, one or more parameters used in the processing by the processing units are different from each other, the processing operations performed by N first to N-th signal processors 120a to 120X are different from each other. Thus, N high-frequency signals that are different from each other can be generated.

### [2. Operations]

Next, operations of audio signal processing device 100 will be described.

FIG. 6 is a flowchart illustrating an example of audio signal processing performed by audio signal processing device 100 according to the embodiment.

First, obtainer 110 obtains audio signal AS1 (S11).

Next, based on audio signal AS1, first to N-th signal processors 120a to 120X generate N high-frequency signals in each of which the sound pressure in the high-frequency range is greater than the sound pressure in the low-frequency range (S12).

Next, adder 130 adds audio signal AS1 obtained by obtainer 110 and the N high-frequency signals generated by N first to N-th signal processors 120a to 120X to thereby generate an expanded audio signal having an expanded high-frequency range (S13).

Next, outputter 140 outputs the expanded audio signal generated by adder 130 (S14).

FIG. 7 is a flowchart illustrating an example of processing that generates a first high-frequency signal among N high-frequency signals according to the embodiment. That is, FIG. 7 illustrates processing that is one part of the processing in step S12 for generating N high-frequency signals.

First, amplifier 121a performs amplification processing of amplifying, by gain G1, audio signal AS1 obtained by obtainer 110(S21).

Next, clipper 122a performs clipping processing of clipping, at amplitude A1, audio signal AS2 obtained by the amplification processing by amplifier 121 (S22).

Next, filter 123a performs high-pass filter processing of passing audio signal AS3 obtained by the first clipping processing through a frequency band (high-frequency range) higher than frequency f1 that is higher than the human hearing range (S23).

Next, attenuator 124a performs attenuation processing of attenuating, by gain G2, audio signal AS4 obtained by the high-pass filter processing by filter 123a (S24).

The first high-frequency signal is generated by execution of the processing in steps S21 to S24.

FIG. 8 is a flowchart illustrating an example of operations that generate a second high-frequency signal among N high-frequency signals according to the embodiment. That is, FIG. 8 illustrates processing that is one part of the processing in step S12 for generating N high-frequency signals.

First, offsetter 125 performs offset processing of offsetting, by a predetermined sound pressure, audio signal AS1 obtained by obtainer 110 (S25).

Next, amplifier 121b performs amplification processing of amplifying, by gain G3, audio signal AS12 obtained by the offset processing by offsetter 125 (S31).

Next, clipper 122b performs clipping processing of clipping, at amplitude A2, audio signal AS13 obtained by the amplification processing by amplifier 121b (S32).

Next, filter 123b performs high-pass filter processing of passing audio signal AS14 obtained by the first clipping processing through a frequency band (high-frequency range) higher than frequency f2 that is higher than the human hearing range (S33).

Next, attenuator 124b performs attenuation processing of attenuating, by gain G4, audio signal AS15 obtained by the high-pass filter processing by filter 123b (S34).

The second high-frequency signal is generated by execution of the processing in steps S25 to S34.

Third to N-th signal processors generates third to N-th high-frequency signals by performing signal processing based on the combination of the configurations of the processing units which each signal processor has, and the parameters used in the processing of each processing unit.

### [3. Effects and the like]

Audio signal processing device 100 according to the present embodiment includes obtainer 110, first signal processor 120a, and adder 130. Obtainer 110 obtains audio signal AS1. First signal processor 120a generates, based on audio signal AS1, a first high-frequency signal including a high-frequency component in a frequency band higher than a first frequency (frequency f1) higher than the human hearing range. Adder 130 adds the first high-frequency signal to audio signal AS1 to generate an expanded audio signal having an expanded high-frequency range. First signal processor 120a generates the first high-frequency signal by performing: (i) first signal processing including first clipping processing of clipping audio signal AS1 at a first amplitude (amplitude A1); and (ii) first high-pass filter processing of passing audio signal AS3 obtained by the first clipping processing through the frequency band higher than the first frequency (frequency f1).

According to this, by performing first signal processing on audio signal AS1 that includes first clipping processing of clipping audio signal AS1 at a first amplitude (amplitude A1), an audio signal that includes more high-frequency components which are based on audio signal AS1 can be generated. Further, since first high-pass filter processing is performed on audio signal AS3 obtained by the first clipping processing, a first high-frequency signal that has a high sound pressure mainly in the high-frequency range can be generated, and by adding the first high-frequency signal to audio signal AS1, an expanded audio signal in which the high-frequency range of audio signal AS1 has been expanded can be generated. Thus, it is possible to easily expand the high-frequency range of audio signal AS1 which does not have 1/f characteristics, which are characteristics as found in audio signals such as some natural sound, thereby reducing discomfort imparted to a person.

Further, in audio signal processing device 100 according to the present embodiment, the first signal processing includes first amplification processing of amplifying audio signal AS1 by a first gain (gain G1), and first clipping processing that is performed on audio signal AS2 obtained by the first amplification processing.

According to this, since a slope of the waveform of audio signal AS2 in a sound pressure range of -A1 or more to A1 or less that is based on amplitude A1 can be made steeper by the amplification processing as compared to before the amplification processing, the angle of a bent shape of the waveform of audio signal AS3 obtained by the clipping processing can be brought close to 90 degrees. Hence, audio signal AS3 that includes more high-frequency components (for example, high-frequency components that are higher than the frequency band of original audio signal AS1 and that fall within the inaudible range of human hearing) can be generated.

Further, in audio signal processing device 100 according to the present embodiment, first signal processor 120a also performs first attenuation processing of attenuating, by a second gain (gain G2), audio signal AS3 obtained by the first clipping processing. The first high-frequency signal is audio signal AS5 obtained by further executing the first attenuation processing.

Therefore, adjustment of the amplitude of audio signal AS4 obtained by the first clipping processing (in the present embodiment, obtained by the first clipping processing and the first high-pass filter processing) that includes more high-frequency components which are based on audio signal AS1 can be performed. Thus, a first high-frequency signal whose amplitude has been appropriately adjusted can be generated, and the high-frequency range of audio signal AS1 can be appropriately expanded.

In addition, audio signal processing device 100 according to the present embodiment further includes second signal processor 120b. Second signal processor 120b generates, based on audio signal AS1, a second high-frequency signal that is different from the first high-frequency signal. Second signal processor 120b generates the second high-frequency signal by performing: (i) second signal processing including offset processing of offsetting audio signal AS1 by predetermined sound pressure ΔSP; (ii) second clipping processing of clipping, at a second amplitude (amplitude A2), audio signal AS13 obtained by the second signal processing; and (iii) second high-pass filter processing of passing audio signal AS14 obtained by the second clipping processing through a frequency band higher than a second frequency (frequency f2) higher than the human hearing range. Adder 130 generates the expanded audio signal by adding the first high-frequency signal and the second high-frequency signal (in the present embodiment, N high-frequency signals including the first high-frequency signal and the second high-frequency signal) to audio signal AS1.

According to this, by performing second clipping processing of clipping, at a second amplitude (amplitude A2), audio signal AS13 obtained by the offset processing and the second amplification processing, an audio signal that includes more high-frequency components which are based on audio signal AS1 can be generated. Audio signal AS3 obtained by the first clipping processing is subjected to the clipping processing without being subjected to offset processing and even order frequency components are canceled out, and therefore audio signal AS3 includes many odd order frequency components, and audio signal AS14 obtained by the second clipping processing is subjected to the clipping processing after the offset processing, and therefore audio signal AS14 includes many even order frequency components since many even order frequency components are not canceled out and remain in audio signal AS14. Therefore, the frequency characteristics of the first high-frequency signal and the second high-frequency signal can be made to differ from each other, and the high-frequency range of audio signal AS1 can be expanded more effectively.

Further, in audio signal processing device 100 according to the present embodiment, the second signal processing includes offset processing and second amplification processing of amplifying, by a third gain (gain G3), audio signal AS12 obtained by the offset processing.

According to this, since a slope in a sound pressure range of - A2 or more to A2 or less that is based on amplitude A2 of the waveform of audio signal AS12 can be made steeper by the amplification processing as compared to before the amplification processing, the angle of a bent shape of the waveform of audio signal AS14 obtained by the clipping processing can be made close to 90 degrees. Hence, audio signal AS14 that includes more high-frequency components (for example, high-frequency components that are higher than the frequency band of original audio signal AS1 and that fall within the inaudible range of human hearing) can be generated.

Furthermore, in audio signal processing device 100 according to the present embodiment, second signal processor 120b further performs second attenuation processing of attenuating, by a fourth gain (gain G4), audio signal AS14 obtained by the second clipping processing. The second high-frequency signal is audio signal AS16 obtained by further executing the second attenuation processing.

Therefore, adjustment of the amplitude of audio signal AS15 obtained by the second clipping processing (in the present embodiment, obtained by the second clipping processing and the second high-pass filter processing) that includes more high-frequency components which are based on audio signal AS1 can be performed. Thus, a second high-frequency signal whose amplitude has been appropriately adjusted can be generated, and the high-frequency range of audio signal AS1 can be more appropriately expanded.

In addition, audio signal processing device 100 according to the present embodiment further includes a third signal processor. The third signal processor generates, based on audio signal AS1, a third high-frequency signal that is different from the first high-frequency signal. The third signal processor generates the third high-frequency signal by performing: (i) third amplification processing of amplifying audio signal AS1 by a fifth gain (gain G5); (ii) third clipping processing of clipping, at a third amplitude (amplitude A3), an audio signal obtained by the third amplification processing and third high-pass filter processing of passing an audio signal obtained by the third clipping processing through a frequency band higher than a third frequency (frequency f3) higher than the human hearing range. Adder 130 generates the expanded audio signal by adding the first high-frequency signal and the third high-frequency signal (in the present embodiment, N high-frequency signals including the first high-frequency signal and the third high-frequency signal) to audio signal AS1.

According to this, by performing third clipping processing of clipping, at a third amplitude, an audio signal obtained by the third amplification processing, an audio signal that includes more high-frequency components which are based on audio signal AS1 can be generated. Further, since third high-pass filter processing is performed on the audio signal obtained by the third clipping processing, a third high-frequency signal that has a high sound pressure mainly in the high-frequency range can be generated. Thus, by adding the first high-frequency signal and the third high-frequency signal to audio signal AS1, an expanded audio signal in which the high-frequency range of audio signal AS1 has been expanded more effectively can be generated.

Further, in audio signal processing device 100 according to the present embodiment, values are different from each other in at least one set among a set of a value of the first gain (gain G1) and a value of the fifth gain (gain G5), a set of a value of the first amplitude (amplitude A1) and a value of the third amplitude (amplitude A3), and a set of a value of the first frequency (frequency f1) and a value of the third frequency (frequency f3).

According to this, since values are different from each other in at least one set among a set of a value of the first gain (gain G1) and a value of the fifth gain (gain G5), a set of a value of the first amplitude (amplitude A1) and a value of the third amplitude (amplitude A3), and a set of a value of the first frequency (frequency f1) and a value of the third frequency (frequency f3), the third high-frequency signal can be generated by processing that is different from the processing that generates the first high-frequency signal. Therefore, the frequency characteristics of the first high-frequency signal and the third high-frequency signal can be made to differ from each other. Thus, by adding the first high-frequency signal and the third high-frequency signal to audio signal AS1, an expanded audio signal in which the high-frequency range of audio signal AS1 has been expanded more effectively can be generated.

### [4. Variations]

Although a configuration is adopted in which audio signal processing device 100 according to the embodiment described above includes N first to N-th signal processors 120a to 120X, it suffices that the configuration includes at least one of N first to N-th signal processors 120a to 120X. This is because at least one high-frequency signal can be generated by at least one signal processor, and an expanded audio signal in which the high-frequency range of audio signal AS1 has been expanded can be generated. That is, although in the embodiment described above a configuration is adopted in which N is an integer of 3 or more, the present disclosure is not limited thereto, and N may be an integer of 1 or more.

Each of the elements in signal processing circuit 104 in each of the above embodiments may be configured in the form of an exclusive hardware product, or may be realized by executing a software program suitable for the element. Each of the elements may be realized by means of a program executing unit, such as a Central Processing Unit (CPU) or a processor, reading and executing the software program recorded on a recording medium such as a hard disk or semiconductor memory.

The elements may be implemented to circuits (or integrated circuits). These circuits may form a single circuit, or serve as separate circuits. Each circuit may be may be a general-purpose circuit or a dedicated circuit.

General or specific aspects of the present disclosure may be implemented to a system, a device, a method, an integrated circuit, a computer program, a non-transitory computer-readable recording medium such as a Compact Disc-Read Only Memory (CD-ROM), or any given combination thereof.

For example, the present disclosure may be implemented to an audio signal processing method performed by an audio signal processing device (computer or Digital Signal Processor (DSP)), or may be implemented to a program for causing a computer or a DSP to execute the audio signal processing method.

For example, it is possible in the above-described embodiments that the process performed by a certain processing unit may be performed by another processing unit, that an order of a plurality of processes performed by audio signal processing device 100 described in the above embodiments is changed, or that a plurality of processes are performed in parallel.

In addition, the present disclosure may include embodiments obtained by making various modifications on the above embodiments which those skilled in the art will arrive at, or embodiments obtained by selectively combining the elements and functions disclosed in the above embodiments, without materially departing from the scope of the present disclosure.

### [Industrial Applicability]

The present disclosure is useful as an audio signal processing device and the like that can easily expand the high-frequency range of an audio signal that does not have 1/f characteristics, which are characteristics as found in audio signals such as some natural sound, thereby reducing discomfort imparted to a person.

### [Reference Signs List]

- 1: Audio signal processing system
- 100: Audio signal processing device
- 101: Communication IF
- 102: Audio input IF
- 103: Storage
- 104: Signal processing circuit
- 110: Obtainer
- 120a: First signal processor
- 120b: Second signal processor
- 120X: N-th signal processor
- 121a, 121b: Amplifier
- 122a, 122b: Clipper
- 123a, 123b: Filter
- 124a, 124b: Attenuator
- 125: Offsetter
- 130: Adder
- 140: Outputter
- 200: Loudspeaker

## Claims

1. An audio signal processing device (100) comprising:
an obtainer (110) configured to obtain (S11) an audio signal (AS1);
a first signal processor (120a) configured to generate (S12), based on the audio signal (AS1), a first high-frequency signal (AS5) including a high-frequency component in a frequency band higher than a first frequency (f1) higher than a human hearing range; and
an adder (130) configured to add (S13) the first high-frequency signal (AS5) to the audio signal (AS1) to generate an expanded audio signal having an expanded high-frequency range, wherein
the first signal processor (120a) is configured to generate (S12) the first high-frequency signal (AS5) by performing:
(i) first signal processing including first clipping processing (S22) of clipping the audio signal at a first amplitude (A1) ; and
(ii) first high-pass filter processing (S23) of passing an audio signal obtained (AS3) by the first clipping processing (S22) through the frequency band higher than the first frequency (f1),
**characterized in that**, the audio signal processing device (100) further comprises:
a second signal processor (120b) configured to generate, based on the audio signal (AS1), a second high-frequency signal (AS16) different from the first high-frequency signal (AS5), wherein
the second signal processor (120b) is configured to generate the second high-frequency signal (AS16) by performing:
(i) second signal processing including offset processing (S25) of offsetting the audio signal (AS1) by a predetermined sound pressure (ΔSP);
(ii) second clipping processing (S32) of clipping, at a second amplitude (A2), an audio signal obtained (AS12) by the second signal processing; and
(iii) second high-pass filter processing (S33) of passing an audio signal obtained (AS14) by the second clipping processing (S32) through a frequency band higher than the human hearing range, and
the adder (130) is configured to generate the expanded audio signal by adding the first high-frequency signal (AS5) and the second high-frequency signal (AS16) to the audio signal (AS1).

2. The audio signal processing device (100) according to claim 1, wherein
the first signal processing includes:
first amplification processing (S21) of amplifying the audio signal (AS1) by a first gain (G1), and
in the first clipping processing (S22), an audio signal obtained (AS2) by the first amplification processing (S21) is clipped (S22) as the audio signal.

3. The audio signal processing device (100) according to claim 2, wherein
the first signal processor (120a) is further configured to perform
first attenuation processing (S24) of attenuating, by a second gain (G2), the audio signal obtained (AS3) by the first clipping processing (S22), and
the first high-frequency signal (AS5) is an audio signal obtained by the first attenuation processing (S24).

4. The audio signal processing device (100) according to claim 2, wherein
the first signal processor (120a) is further configured to perform
first equalizing processing of amplifying or attenuating a certain frequency band of an audio signal obtained (AS4) by the first high-pass filter processing (S23), and
the first high-frequency signal (AS5) is an audio signal obtained by the first equalizing processing.

5. The audio signal processing device (100) according to claim 2, wherein
the first signal processor (120a) is further configured to perform:
first attenuation processing (S24) of attenuating, by a second gain (G2), the audio signal (AS3) obtained by the first clipping processing (S22); and
first equalizing processing of amplifying or attenuating a certain frequency band of an audio signal obtained by the first attenuation processing (S24), and
the first high-frequency signal (AS5) is an audio signal obtained by the first equalizing processing.

6. The audio signal processing device according to any one of claims 1 to 5, wherein
the second high-pass filter processing (S33) passes an audio signal obtained (AS14) by the second clipping processing (S32) through a frequency band higher than a second frequency (f2) higher than the human hearing range.

7. The audio signal processing device (100) according to claim 6, wherein
the second signal processing includes:
the offset processing (S25); and
second amplification processing (S31) of amplifying, by a third gain (G3), an audio signal obtained by the offset processing (S25).

8. The audio signal processing device (100) according to claim 7, wherein
the second signal processor (120b) is further configured to perform
second attenuation processing (S34) of attenuating, by a fourth gain (G4), the audio signal obtained (AS14) by the second clipping processing (S32), and
the second high-frequency signal (AS16) is an audio signal obtained by the second attenuation processing (S34).

9. The audio signal processing device (100) according to claim 7, wherein
the second signal processor (120b) is further configured to perform
second equalizing processing of amplifying or attenuating a certain frequency range of an audio signal obtained (AS15) by the second high-pass filter processing (S33), and
the second high-frequency signal (AS16) is an audio signal obtained by the second equalizing processing.

10. The audio signal processing device (100) according to claim 7, wherein
the second signal processor (120b) is further configured to perform:
second attenuation processing (S34) of attenuating, by a fourth gain (G4), the audio signal obtained (AS14) by the second clipping processing (S32); and
second equalizing processing of amplifying or attenuating a certain frequency range of an audio signal obtained by the second attenuation processing (S34), and
the second high-frequency signal (AS16) is an audio signal obtained by the second equalizing processing.

11. The audio signal processing device (100) according to any one of claims 2 to 5, further comprising:
a third signal processor configured to generate, based on the audio signal (AS1), a third high-frequency signal different from the first high-frequency signal (AS5), wherein
the third signal processor is configured to generate the third high-frequency signal by performing:
(i) third amplification processing of amplifying the audio signal (AS1) by a fifth gain (G5);
(ii) third clipping processing of clipping, at a third amplitude (A3), an audio signal obtained by the third amplification processing; and
(iii) third high-pass filter processing of passing an audio signal obtained by the third clipping processing through a frequency band higher than a third frequency (f3) higher than the human hearing range, and
the adder (130) is configured to generate the expanded audio signal by adding the first high-frequency signal (AS5) and/or the second high-frequency signal (AS16) to the third high-frequency signal to the audio signal (AS1).

12. The audio signal processing device (100) according to claim 11, wherein
values are different from each other in at least one set among (i) a set of a value of the first gain (G1) and a value of the fifth gain (G5), (ii) a set of a value of the first amplitude (A1) and a value of the third amplitude (A3), and (iii) a set of a value of the first frequency (f1) and a value of the third frequency (f3).

13. An audio signal processing method comprising:
obtaining (S11) an audio signal (AS1);
generating (S12), based on the audio signal (AS1), a first high-frequency signal (AS5) including a high-frequency component in a frequency band higher than a first frequency (f1) higher than a human hearing range; and wherein,
the generating (S12) of the first high-frequency signal (AS5) includes:
(i) first signal processing including first clipping processing (S22) of clipping the audio signal at a first amplitude (A1); and
(ii) first high-pass filter processing (S23) of passing an audio signal (AS3) obtained by the first clipping processing (S22) through the frequency band higher than the first frequency (f1),
**characterized in that**
the audio signal processing method further comprises the steps of:
generating, based on the audio signal (AS1), a second high-frequency signal (AS16) different from the first high-frequency signal (AS5), wherein
the generating (S12) of the second high-frequency signal (AS16) includes:
(i) second signal processing including offset processing (S25) of offsetting the audio signal (AS1) by a predetermined sound pressure (ΔSP);
(ii) second clipping processing (S32) of clipping, at a second amplitude (A2), an audio signal obtained (AS12) by the second signal processing; and
(iii) second high-pass filter processing (S33) of passing an audio signal obtained (AS14) by the second clipping processing (S32) through a frequency band higher than the human hearing range, and
adding the first high-frequency signal (AS5) and the second high-frequency signal (AS16) to the audio signal (AS1), to generate the expanded audio signal.

14. A program for causing a computer to execute the audio signal processing method according to claim 13.

## Patentansprüche

1. Audiosignalverarbeitungsvorrichtung (100), umfassend:
eine Erfassungseinheit (110), die dazu ausgebildet ist, ein Audiosignal (AS1) zu erfassen (S11);
einen ersten Signalprozessor (120a), der dazu ausgebildet ist, auf der Grundlage des Audiosignals (AS1) ein erstes Hochfrequenzsignal (AS5) zu erzeugen (S12), das eine Hochfrequenzkomponente in einem Frequenzband höher als eine erste Frequenz (f1) höher als ein menschlicher Hörbereich umfasst; und
einen Addierer (130), der dazu ausgebildet ist, das erste Hochfrequenzsignal (AS5) zu dem Audiosignal (AS1) hinzuzufügen (S13), um ein erweitertes Audiosignal mit einem erweiterten Hochfrequenzbereich zu erzeugen, wobei
der erste Signalprozessor (120a) dazu ausgebildet ist, das erste Hochfrequenzsignal (AS5) zu erzeugen (S12), indem er ausführt:
(i) eine erste Signalverarbeitung, die eine erste Begrenzungsverarbeitung (S22) umfasst, bei der das Audiosignal bei einer ersten Amplitude (A1) begrenzt wird; und
(ii) eine erste Hochpassfilterverarbeitung (S23), bei der ein durch die erste Begrenzungsverarbeitung (S22) erhaltenes Audiosignal (AS3) durch das Frequenzband höher als die erste Frequenz (f1) durchgelassen wird,
**dadurch gekennzeichnet, dass** die Audiosignalverarbeitungsvorrichtung (100) ferner umfasst:
einen zweiten Signalprozessor (120b), der dazu ausgebildet ist, auf der Grundlage des Audiosignals (AS1) ein zweites Hochfrequenzsignal (AS16) zu erzeugen, das sich von dem ersten Hochfrequenzsignal (AS5) unterscheidet, wobei
der zweite Signalprozessor (120b) dazu ausgebildet ist, das zweite Hochfrequenzsignal (AS16) zu erzeugen, indem er ausführt:
(i) eine zweite Signalverarbeitung, die eine Versatzverarbeitung (S25) umfasst, bei der das Audiosignal (AS1) um einen vorbestimmten Schalldruck (ΔSP) versetzt wird;
(ii) eine zweite Begrenzungsverarbeitung (S32), bei der ein durch die zweite Signalverarbeitung erhaltenes Audiosignal (AS12) bei einer zweiten Amplitude (A2) begrenzt wird; und
(iii) eine zweite Hochpassfilterverarbeitung (S33), bei der ein durch die zweite Begrenzungsverarbeitung (S32) erhaltenes Audiosignal (AS14) durch ein Frequenzband höher als der menschliche Hörbereich durchgelassen wird, und
der Addierer (130) dazu ausgebildet ist, das erweiterte Audiosignal zu erzeugen, indem er das erste Hochfrequenzsignal (AS5) und das zweite Hochfrequenzsignal (AS16) zu dem Audiosignal (AS1) hinzufügt.

2. Audiosignalverarbeitungsvorrichtung (100) nach Anspruch 1, wobei
die erste Signalverarbeitung umfasst:
eine erste Verstärkungsverarbeitung (S21), bei der das Audiosignal (AS1) um einen ersten Verstärkungsfaktor (G1) verstärkt wird, und
bei der ersten Begrenzungsverarbeitung (S22) ein durch die erste Verstärkungsverarbeitung (S21) erhaltenes Audiosignal (AS2) als das Audiosignal begrenzt wird (S22).

3. Audiosignalverarbeitungsvorrichtung (100) nach Anspruch 2, wobei
der erste Signalprozessor (120a) ferner dazu ausgebildet ist, auszuführen:
eine erste Dämpfungsverarbeitung (S24), bei der das durch die erste Begrenzungsverarbeitung (S22) erhaltene Audiosignal (AS3) um einen zweiten Verstärkungsfaktor (G2) gedämpft wird, und
das erste Hochfrequenzsignal (AS5) ein durch die erste Dämpfungsverarbeitung (S24) erhaltenes Audiosignal ist.

4. Audiosignalverarbeitungsvorrichtung (100) nach Anspruch 2, wobei
der erste Signalprozessor (120a) ferner dazu ausgebildet ist, auszuführen:
eine erste Entzerrungsverarbeitung, bei der ein bestimmtes Frequenzband eines durch die erste Hochpassfilterverarbeitung (S23) erhaltenen Audiosignals (AS4) verstärkt oder gedämpft wird, und
das erste Hochfrequenzsignal (AS5) ein durch die erste Entzerrungsverarbeitung erhaltenes Audiosignal ist.

5. Audiosignalverarbeitungsvorrichtung (100) nach Anspruch 2, wobei
der erste Signalprozessor (120a) ferner dazu ausgebildet ist, auszuführen:
eine erste Dämpfungsverarbeitung (S24), bei der das durch die erste Begrenzungsverarbeitung (S22) erhaltene Audiosignal (AS3) um einen zweiten Verstärkungsfaktor (G2) gedämpft wird; und
eine erste Entzerrungsverarbeitung, bei der ein bestimmtes Frequenzband eines durch die erste Dämpfungsverarbeitung (S24) erhaltenen Audiosignals verstärkt oder gedämpft wird, und
das erste Hochfrequenzsignal (AS5) ein durch die erste Entzerrungsverarbeitung erhaltenes Audiosignal ist.

6. Audiosignalverarbeitungsvorrichtung nach einem der Ansprüche 1 bis 5, wobei
die zweite Hochpassfilterverarbeitung (S33) ein durch die zweite Begrenzungsverarbeitung (S32) erhaltenes Audiosignal (AS14) durch ein Frequenzband höher als eine zweite Frequenz (f2) höher als der menschliche Hörbereich durchlässt.

7. Audiosignalverarbeitungsvorrichtung (100) nach Anspruch 6, wobei
die zweite Signalverarbeitung umfasst:
die Versatzverarbeitung (S25); und
eine zweite Verstärkungsverarbeitung (S31), bei der ein durch die Versatzverarbeitung (S25) erhaltenes Audiosignal um einen dritten Verstärkungsfaktor (G3) verstärkt wird.

8. Audiosignalverarbeitungsvorrichtung (100) nach Anspruch 7, wobei
der zweite Signalprozessor (120b) ferner dazu ausgebildet ist, auszuführen:
eine zweite Dämpfungsverarbeitung (S34), bei der das durch die zweite Begrenzungsverarbeitung (S32) erhaltene Audiosignal (AS14) um einen vierten Verstärkungsfaktor (G4) gedämpft wird, und
das zweite Hochfrequenzsignal (AS16) ein durch die zweite Dämpfungsverarbeitung (S34) erhaltenes Audiosignal ist.

9. Audiosignalverarbeitungsvorrichtung (100) nach Anspruch 7, wobei
der zweite Signalprozessor (120b) ferner dazu ausgebildet ist, auszuführen:
eine zweite Entzerrungsverarbeitung, bei der ein bestimmter Frequenzbereich eines durch die zweite Hochpassfilterverarbeitung (S33) erhaltenen Audiosignals (AS15) verstärkt oder gedämpft wird, und
das zweite Hochfrequenzsignal (AS16) ein durch die zweite Entzerrungsverarbeitung erhaltenes Audiosignal ist.

10. Audiosignalverarbeitungsvorrichtung (100) nach Anspruch 7, wobei
der zweite Signalprozessor (120b) ferner dazu ausgebildet ist, auszuführen:
eine zweite Dämpfungsverarbeitung (S34), bei der das durch die zweite Begrenzungsverarbeitung (S32) erhaltene Audiosignal (AS14) um einen vierten Verstärkungsfaktor (G4) gedämpft wird; und
eine zweite Entzerrungsverarbeitung, bei der ein bestimmter Frequenzbereich eines durch die zweite Dämpfungsverarbeitung (S34) erhaltenen Audiosignals verstärkt oder gedämpft wird, und
das zweite Hochfrequenzsignal (AS16) ein durch die zweite Entzerrungsverarbeitung erhaltenes Audiosignal ist.

11. Audiosignalverarbeitungsvorrichtung (100) nach einem der Ansprüche 2 bis 5, ferner umfassend:
einen dritten Signalprozessor, der dazu ausgebildet ist, auf der Grundlage des Audiosignals (AS1) ein drittes Hochfrequenzsignal zu erzeugen, das sich von dem ersten Hochfrequenzsignal (AS5) unterscheidet, wobei
der dritte Signalprozessor dazu ausgebildet ist, das dritte Hochfrequenzsignal zu erzeugen, indem er ausführt:
(i) eine dritte Verstärkungsverarbeitung, bei der das Audiosignal (AS1) um einen fünften Verstärkungsfaktor (G5) verstärkt wird;
(ii) eine dritte Begrenzungsverarbeitung, bei der ein durch die dritte Verstärkungsverarbeitung erhaltenes Audiosignal bei einer dritten Amplitude (A3) begrenzt wird; und
(iii) eine dritte Hochpassfilterverarbeitung, bei der ein durch die dritte Begrenzungsverarbeitung erhaltenes Audiosignal durch ein Frequenzband höher als eine dritte Frequenz (f3) höher als der menschliche Hörbereich durchgelassen wird, und
der Addierer (130) dazu ausgebildet ist, das erweiterte Audiosignal zu erzeugen, indem er das erste Hochfrequenzsignal (AS5) und/oder das zweite Hochfrequenzsignal (AS16) zu dem dritten Hochfrequenzsignal zu dem Audiosignal (AS1) hinzufügt.

12. Audiosignalverarbeitungsvorrichtung (100) nach Anspruch 11, wobei
sich Werte in mindestens einem Satz voneinander unterscheiden unter (i) einem Satz aus einem Wert des ersten Verstärkungsfaktors (G1) und einem Wert des fünften Verstärkungsfaktors (G5), (ii) einem Satz aus einem Wert der ersten Amplitude (A1) und einem Wert der dritten Amplitude (A3), und (iii) einem Satz aus einem Wert der ersten Frequenz (f1) und einem Wert der dritten Frequenz (f3).

13. Audiosignalverarbeitungsverfahren, umfassend:
Erfassen (S11) eines Audiosignals (AS1);
Erzeugen (S12), auf der Grundlage des Audiosignals (AS1), eines ersten Hochfrequenzsignals (AS5), das eine Hochfrequenzkomponente in einem Frequenzband höher als eine erste Frequenz (f1) höher als ein menschlicher Hörbereich umfasst; und wobei,
das Erzeugen (S12) des ersten Hochfrequenzsignals (AS5) umfasst:
(i) eine erste Signalverarbeitung, die eine erste Begrenzungsverarbeitung (S22) umfasst, bei der das Audiosignal bei einer ersten Amplitude (A1) begrenzt wird; und
(ii) eine erste Hochpassfilterverarbeitung (S23), bei der ein durch die erste Begrenzungsverarbeitung (S22) erhaltenes Audiosignal (AS3) durch das Frequenzband höher als die erste Frequenz (f1) durchgelassen wird,
**dadurch gekennzeichnet, dass**
das Audiosignalverarbeitungsverfahren ferner die Schritte umfasst:
Erzeugen, auf der Grundlage des Audiosignals (AS1), eines zweiten Hochfrequenzsignals (AS16), das sich von dem ersten Hochfrequenzsignal (AS5) unterscheidet, wobei das Erzeugen (S12) des zweiten Hochfrequenzsignals (AS16) umfasst:
(i) eine zweite Signalverarbeitung, die eine Versatzverarbeitung (S25) umfasst, bei der das Audiosignal (AS1) um einen vorbestimmten Schalldruck (ΔSP) versetzt wird;
(ii) eine zweite Begrenzungsverarbeitung (S32), bei der ein durch die zweite Signalverarbeitung erhaltenes Audiosignal (AS12) bei einer zweiten Amplitude (A2) begrenzt wird; und
(iii) eine zweite Hochpassfilterverarbeitung (S33), bei der ein durch die zweite Begrenzungsverarbeitung (S32) erhaltenes Audiosignal (AS14) durch ein Frequenzband höher als der menschliche Hörbereich durchgelassen wird, und
Hinzufügen des ersten Hochfrequenzsignals (AS5) und des zweiten Hochfrequenzsignals (AS16) zu dem Audiosignal (AS1), um das erweiterte Audiosignal zu erzeugen.

14. Programm zum Veranlassen eines Computers, das Audiosignalverarbeitungsverfahren nach Anspruch 13 auszuführen.

## Revendications

1. Dispositif de traitement de signal audio (100) comprenant :
un obtenteur (110) configuré pour obtenir (S11) un signal audio (AS1) ;
un premier processeur de signal (120a) configuré pour générer (S12), sur la base du signal audio (AS1), un premier signal haute fréquence (AS5) comprenant une composante haute fréquence dans une bande de fréquence supérieure à une première fréquence (f1) supérieure à une plage d'audition humaine ; et
un additionneur (130) configuré pour ajouter (S13) le premier signal haute fréquence (AS5) au signal audio (AS1) afin de générer un signal audio étendu ayant une plage haute fréquence étendue, dans lequel
le premier processeur de signal (120a) est configuré pour générer (S12) le premier signal haute fréquence (AS5) en effectuant :
(i) un premier traitement de signal comprenant un premier traitement d'écrêtage (S22) consistant à écrêter le signal audio à une première amplitude (A1) ; et
(ii) un premier traitement de filtre passe-haut (S23) consistant à faire passer un signal audio obtenu (AS3) par le premier traitement d'écrêtage (S22) à travers la bande de fréquence supérieure à la première fréquence (f1),
**caractérisé en ce que** le dispositif de traitement de signal audio (100) comprend en outre :
un deuxième processeur de signal (120b) configuré pour générer, sur la base du signal audio (AS1), un deuxième signal haute fréquence (AS16) différent du premier signal haute fréquence (AS5), dans lequel
le deuxième processeur de signal (120b) est configuré pour générer le deuxième signal haute fréquence (AS16) en effectuant :
(i) un deuxième traitement de signal comprenant un traitement de décalage (S25) consistant à décaler le signal audio (AS1) d'une pression acoustique prédéterminée (ΔSP) ;
(ii) un deuxième traitement d'écrêtage (S32) consistant à écrêter, à une deuxième amplitude (A2), un signal audio obtenu (AS12) par le deuxième traitement de signal ; et
(iii) un deuxième traitement de filtre passe-haut (S33) consistant à faire passer un signal audio obtenu (AS14) par le deuxième traitement d'écrêtage (S32) à travers une bande de fréquence supérieure à la plage d'audition humaine, et
l'additionneur (130) est configuré pour générer le signal audio étendu en ajoutant le premier signal haute fréquence (AS5) et le deuxième signal haute fréquence (AS16) au signal audio (AS1).

2. Dispositif de traitement de signal audio (100) selon la revendication 1, dans lequel
le premier traitement de signal comprend :
un premier traitement d'amplification (S21) consistant à amplifier le signal audio (AS1) par un premier gain (G1), et
dans le premier traitement d'écrêtage (S22), un signal audio obtenu (AS2) par le premier traitement d'amplification (S21) est écrêté (S22) en tant que signal audio.

3. Dispositif de traitement de signal audio (100) selon la revendication 2, dans lequel
le premier processeur de signal (120a) est en outre configuré pour effectuer un premier traitement d'atténuation (S24) consistant à atténuer, par un deuxième gain (G2), le signal audio obtenu (AS3) par le premier traitement d'écrêtage (S22), et
le premier signal haute fréquence (AS5) est un signal audio obtenu par le premier traitement d'atténuation (S24).

4. Dispositif de traitement de signal audio (100) selon la revendication 2, dans lequel
le premier processeur de signal (120a) est en outre configuré pour effectuer un premier traitement d'égalisation consistant à amplifier ou atténuer une certaine bande de fréquence d'un signal audio obtenu (AS4) par le premier traitement de filtre passe-haut (S23), et
le premier signal haute fréquence (AS5) est un signal audio obtenu par le premier traitement d'égalisation.

5. Dispositif de traitement de signal audio (100) selon la revendication 2, dans lequel
le premier processeur de signal (120a) est en outre configuré pour effectuer :
un premier traitement d'atténuation (S24) consistant à atténuer, par un deuxième gain (G2), le signal audio (AS3) obtenu par le premier traitement d'écrêtage (S22) ; et
un premier traitement d'égalisation consistant à amplifier ou atténuer une certaine bande de fréquence d'un signal audio obtenu par le premier traitement d'atténuation (S24), et
le premier signal haute fréquence (AS5) est un signal audio obtenu par le premier traitement d'égalisation.

6. Dispositif de traitement de signal audio selon l'une quelconque des revendications 1 à 5, dans lequel
le deuxième traitement de filtre passe-haut (S33) fait passer un signal audio obtenu (AS14) par le deuxième traitement d'écrêtage (S32) à travers une bande de fréquence supérieure à une deuxième fréquence (f2) supérieure à la plage d'audition humaine.

7. Dispositif de traitement de signal audio (100) selon la revendication 6, dans lequel
le deuxième traitement de signal comprend :
le traitement de décalage (S25) ; et
un deuxième traitement d'amplification (S31) consistant à amplifier, par un troisième gain (G3), un signal audio obtenu par le traitement de décalage (S25).

8. Dispositif de traitement de signal audio (100) selon la revendication 7, dans lequel
le deuxième processeur de signal (120b) est en outre configuré pour effectuer un deuxième traitement d'atténuation (S34) consistant à atténuer, par un quatrième gain (G4), le signal audio obtenu (AS14) par le deuxième traitement d'écrêtage (S32), et
le deuxième signal haute fréquence (AS16) est un signal audio obtenu par le deuxième traitement d'atténuation (S34).

9. Dispositif de traitement de signal audio (100) selon la revendication 7, dans lequel
le deuxième processeur de signal (120b) est en outre configuré pour effectuer un deuxième traitement d'égalisation consistant à amplifier ou atténuer une certaine plage de fréquence d'un signal audio obtenu (AS15) par le deuxième traitement de filtre passe-haut (S33), et
le deuxième signal haute fréquence (AS16) est un signal audio obtenu par le deuxième traitement d'égalisation.

10. Dispositif de traitement de signal audio (100) selon la revendication 7, dans lequel
le deuxième processeur de signal (120b) est en outre configuré pour effectuer :
un deuxième traitement d'atténuation (S34) consistant à atténuer, par un quatrième gain (G4), le signal audio obtenu (AS14) par le deuxième traitement d'écrêtage (S32) ; et
un deuxième traitement d'égalisation consistant à amplifier ou atténuer une certaine plage de fréquence d'un signal audio obtenu par le deuxième traitement d'atténuation (S34), et
le deuxième signal haute fréquence (AS16) est un signal audio obtenu par le deuxième traitement d'égalisation.

11. Dispositif de traitement de signal audio (100) selon l'une quelconque des revendications 2 à 5, comprenant en outre :
un troisième processeur de signal configuré pour générer, sur la base du signal audio (AS1), un troisième signal haute fréquence différent du premier signal haute fréquence (AS5), dans lequel
le troisième processeur de signal est configuré pour générer le troisième signal haute fréquence en effectuant :
(i) un troisième traitement d'amplification consistant à amplifier le signal audio (AS1) par un cinquième gain (G5) ;
(ii) un troisième traitement d'écrêtage consistant à écrêter, à une troisième amplitude (A3), un signal audio obtenu par le troisième traitement d'amplification ; et
(iii) un troisième traitement de filtre passe-haut consistant à faire passer un signal audio obtenu par le troisième traitement d'écrêtage à travers une bande de fréquence supérieure à une troisième fréquence (f3) supérieure à la plage d'audition humaine, et
l'additionneur (130) est configuré pour générer le signal audio étendu en ajoutant le premier signal haute fréquence (AS5) et/ou le deuxième signal haute fréquence (AS16) au troisième signal haute fréquence au signal audio (AS1).

12. Dispositif de traitement de signal audio (100) selon la revendication 11, dans lequel
les valeurs sont différentes les unes des autres dans au moins un ensemble parmi (i) un ensemble d'une valeur du premier gain (G1) et d'une valeur du cinquième gain (G5), (ii) un ensemble d'une valeur de la première amplitude (A1) et d'une valeur de la troisième amplitude (A3), et (iii) un ensemble d'une valeur de la première fréquence (f1) et d'une valeur de la troisième fréquence (f3).

13. Procédé de traitement de signal audio comprenant :
l'obtention (S11) d'un signal audio (AS1) ;
la génération (S12), sur la base du signal audio (AS1), d'un premier signal haute fréquence (AS5) comprenant une composante haute fréquence dans une bande de fréquence supérieure à une première fréquence (f1) supérieure à une plage d'audition humaine ; et dans lequel,
la génération (S12) du premier signal haute fréquence (AS5) comprend :
(i) un premier traitement de signal comprenant un premier traitement d'écrêtage (S22) consistant à écrêter le signal audio à une première amplitude (A1) ; et
(ii) un premier traitement de filtre passe-haut (S23) consistant à faire passer un signal audio (AS3) obtenu par le premier traitement d'écrêtage (S22) à travers la bande de fréquence supérieure à la première fréquence (f1),
**caractérisé en ce que**
le procédé de traitement de signal audio comprend en outre les étapes consistant à :
générer, sur la base du signal audio (AS1), un deuxième signal haute fréquence (AS16) différent du premier signal haute fréquence (AS5), dans lequel
la génération (S12) du deuxième signal haute fréquence (AS16) comprend :
(i) un deuxième traitement de signal comprenant un traitement de décalage (S25) consistant à décaler le signal audio (AS1) d'une pression acoustique prédéterminée (ΔSP) ;
(ii) un deuxième traitement d'écrêtage (S32) consistant à écrêter, à une deuxième amplitude (A2), un signal audio obtenu (AS12) par le deuxième traitement de signal ; et
(iii) un deuxième traitement de filtre passe-haut (S33) consistant à faire passer un signal audio obtenu (AS14) par le deuxième traitement d'écrêtage (S32) à travers une bande de fréquence supérieure à la plage d'audition humaine, et
ajouter le premier signal haute fréquence (AS5) et le deuxième signal haute fréquence (AS16) au signal audio (AS1), afin de générer le signal audio étendu.

14. Programme pour amener un ordinateur à exécuter le procédé de traitement de signal audio selon la revendication 13.
